(19) Europäisches Patentamt
European Patent Office
Office européen des brevets

(11) **EP 3 753 101 B1**

(12) **EUROPEAN PATENT SPECIFICATION**

(45) Date of publication and mention
of the grant of the patent:
**15.09.2021 Bulletin 2021/37**

(51) Int Cl.:
**H02S 20/23** *(2014.01)*

(21) Application number: **19806343.0**

(86) International application number:
**PCT/TR2019/050072**

(22) Date of filing: **06.02.2019**

(87) International publication number:
**WO 2020/022983 (30.01.2020 Gazette 2020/05)**

(54) **A SOLAR PANEL FOR INDUSTRIAL ROOFS AND A ROOF WHEREIN THIS SOLAR PANEL IS APPLIED**

SOLARPANEEL FÜR INDUSTRIEDÄCHER UND DACH, AUF DEM DIESES SOLARPANEEL ANGEBRACHT IST

PANNEAU SOLAIRE POUR TOITS INDUSTRIELS ET TOIT DANS LEQUEL EST APPLIQUÉ CE PANNEAU SOLAIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.02.2018 TR 201801945**

(43) Date of publication of application:
**23.12.2020 Bulletin 2020/52**

(73) Proprietor: **YAVUZ, Mehmet Nazim
34750 Istanbul (TR)**

(72) Inventor: **YAVUZ, Mehmet Nazim
34750 Istanbul (TR)**

(74) Representative: **Sevinç, Erkan
Istanbul Patent A.S.
Plaza-33, Büyükdere Cad. No: 33/16
Sisli
34381 Istanbul (TR)**

(56) References cited:
**CN-B- 102 709 358         DE-A1-102015 118 683
US-A- 4 860 509           US-A1- 2005 178 428
US-A1- 2008 245 405       US-B2- 9 021 752**

## Description

### Technical Field

This invention is related to a solar panel for industrial roofs like house, fabric, plaza, school roofs and to a roof wherein this solar panel is applied.

### Prior Art

Nowadays, sun - energy systems and sun panels therefor become undeniably more of an issue to diversify the energy sources. Solar panel is an energy source; on which it includes several solar cells for absorbing sun energy.

On the other hand, load carrying capacity of the industrial featured roofs are weak. On this reason, as weights of solar electric production systems and of solar panel constructions to be applied on a roof are heavy, montage on roofs thereof is quite difficult. Drilling or over loading these roofs causes collapsing of the roof. Mounting of more than one person on these roofs also results in to increase of weight more and more with the solar panel's weight on the roof. This, makes it impossible to constitute a roof comprising a solar panel which works efficiently.

On the other hand, in the state of the art, solar panel setups of the industrial roofs have been performed via drilling of the roof or in a way to destroy the roof integrity. This, causes disruption of the water and heat insulation of the roof.

Patent application DE102015118683 A1 discloses a solar panel with a membrane as a base layer according to the preamble of claim 1.

### Brief Description of the Invention

The aim of the invention is, to realize a solar panel that will not harm water and heat insulation of the industrial roofs like home, school, hospital, plaza, fabric, warehouse roofs and will support such insulation.

Another aim of this invention is, to realize a solar panel that is light enough to allow to be installed by a single person.

Another aim of this invention is, to realize a solar panel of which the production can be made practically and which can be installed to the roof practically.

The solar panel of the invention is defined in claim 1.

Main layers in the solar panel are; membrane, back sheet, solar cell layer and front face protection layer. Between these main layers: upper, lower and lowermost protection layer, i.e. EVA material is provided.

Upper, lower and lowermost protection layers are EVA (Ethylene Vinyl Acetate) membrane one each.

Front face protection layer is a tempered glass.

Membrane comprises a TPO thermoplastic polyolefin and/or PVC Polyvinyl Chloride.

The junction unit is placed in such a way that it does not prevent the membrane's lower surface to be laminated to the roof.

In one embodiment of the invention, the junction unit is positioned on the back sheet. Back sheet comprises a protrusion for positioning of the junction unit. In an alternative of this embodiment of the invention, this protrusion overhangs from one short side (i.e. edge) of the back sheet. In these embodiments, the junction unit is positioned on the protrusion.

In another embodiment of the invention, the junction unit is positioned on the front face protection layer.

Surface area of the membrane is bigger than surface areas of the front face protection layer, upper protection layer, solar cell layer, lower protection layer, back sheet and lowermost protection layer.

The front face protection layer has a surface area in a size that covers surface area of the solar cell layer.

Back sheet has a surface area, which is more than front face protection layer's and solar cell layer's surface areas and less than membrane's surface area.

Upper, lower and lowermost protection interlayers, have surface areas equal to each other in such a way that to provide sealing of main layers to each other and more than front face protection layer's surface area in such a manner that to protrude out of front face protection layer's surface are in a predetermined amount.

In an embodiment of the invention, the sides of upper, lower and lowermost protection layers are dimensioned such that the sides protrude out of the front face protection layer's sides approximately 2 cm.

The ratio of a long side of the front face protection layer to a long side of the membrane is a number between 0,6 to 1 or equal to one of these numbers.

The ratio of a short side of the front face protection layer to a short side of the membrane is a number between 0,5 to 1 or equal to one of these numbers.

The ratio of the distance between a short or long side length of the membrane and a short or long side of the front face protection layer to the short or long side's length of the membrane is a number between 0 to 1 or equal to one of these numbers.

In an embodiment of the invention, long side of the front face protection layer is approximately 16 cm and short side is approximately 10 cm and long side of the membrane is approximately 18 cm and short side is approximately 12 cm.

A roof or roof system comprising a solar panel as described above is disclosed to understand the invention. Such solar panel is fixed from its membrane to the roof from a membrane which is the uppermost layer of the roof via a lamination process.

Industrial roof used in the invention is an inclined or a bowless roof wherein its uppermost layer comprises a synthetic membrane and/or a sandwich panel and/or a trapeze plate.

## Detailed Description of the Invention

### Description of the Figures:

[0028]

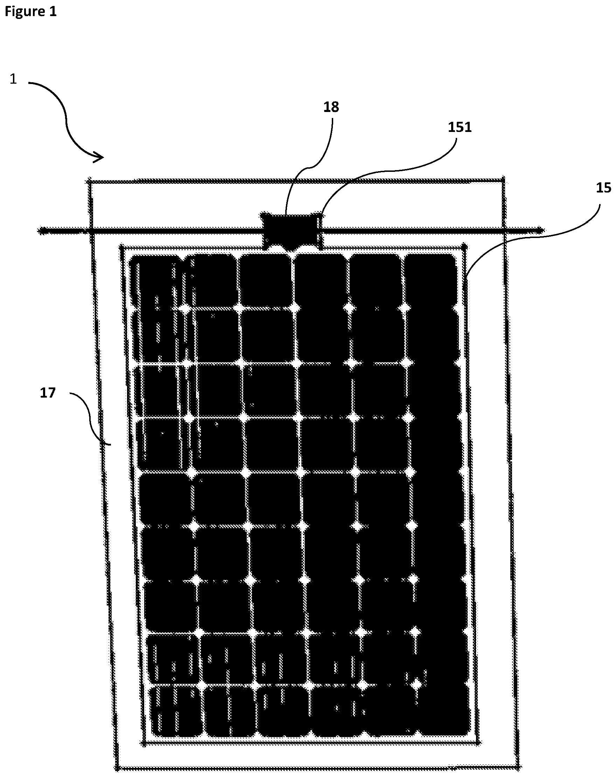

　　　Figure 1: In an embodiment of the invention, top view of the solar panel wherein its layers are sealed to each other.

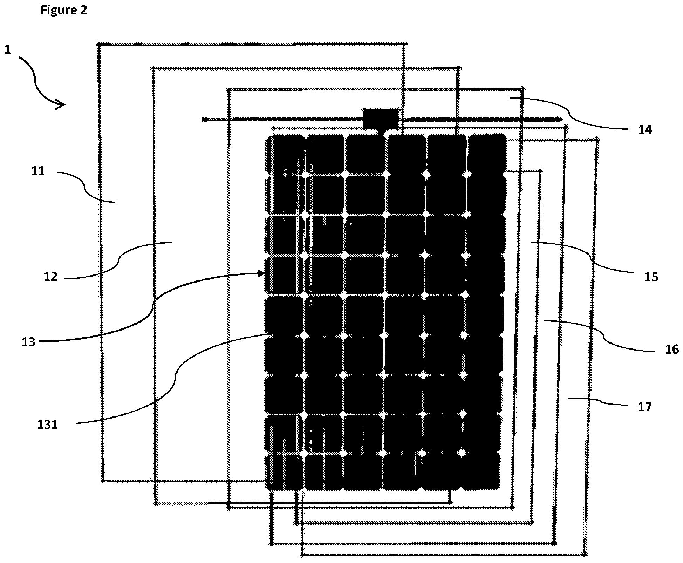

　　　Figure 2: Exploded view of the solar panel, in the invention's embodiment of Figure 1.

Description of the references in the figures:

　　1. Solar panel

　　　　11. Front face protection layer
　　　　12. Upper protection layer
　　　　13. Solar cell layer
　　　　131. Solar cell
　　　　14. Lower protection layer
　　　　15. Back sheet
　　　　151. Protrusion
　　　　16. Lowermost protection layer
　　　　17. Membrane
　　　　18. Junction unit

Solar panel (1) subject to the invention comprises: a membrane (17) as a base layer wherein the base layer is to be integrated to an industrial roof and from the bottom to the uppermost respectively: a lowermost protection layer (16) on this membrane (17); electrical isolation back sheet (15) on this lowermost protection layer (16); a lower protection layer (14) on this electrical isolation back sheet (15); a solar cell layer (13) on this lower protection layer (14); an upper protection layer (12) on this solar cell layer (13); and a front face protection layer (11) on this upper protection layer (12).

The solar panel (1) subject to the invention does not comprise any other layer between these above cited layers (i.e. 11, 12, 13, 14, 15, 16, 17). Therefore, the weight of the solar panel is decreased and a very lightweight panel is realized.

In the solar panel (1) subject to invention, main layers are; membrane (17), back sheet (15), solar cell layer (13) and front face protection layer (11). Between these main layers, interlayers i.e. upper, lower and lowermost protection layers (12, 14, 16) is provided.

Solar cell layer (13), comprises solar (i.e. photovoltaic) cells (131) that provides electricity production.

The solar panel (1) subject to the invention also comprises a junction unit (18). This unit (18), provides solar cell layer (13) of the solar panel (1) to produce electrical output wherein the solar cell layer (13) is composed of via serial or parallel connected solar cells (131).

Front face protection layer (11), is a tempered glass, namely is a heat treated glass.

Upper, lower and lowermost protection layers (12, 14 and 16) are EVA (Ethylene Vinyl Acetate) membrane one each. Such protection layers (12, 14 and 16) are commercially known in the market as "encapsulate EVA" which is a layer that is covered to lower and upper parts of the classical solar cell (131).

Back sheet (15) is an electrical isolation layer.

Membrane (17), which takes part at the bottom and will be mounted on the roof, comprises a TPO thermoplastic polyolefin and/or PVC Polyvinyl Chloride.

Solar panel (1) subject to invention, is fixed directly to a membrane layer which takes part at the uppermost place of the industrial roof, via the membrane (17) which is at the lowermost place of the solar panel (1). Fixing process is performed by bonding via heating namely lamination.

Junction unit (18), is a unit that collects the energy that arrives from solar cells. Preferably this unit is a junction box. Junction unit (18), is positioned in such a way that it does not prevent the lower surface of the membrane (17) to be laminated to the roof, namely, in a position that it will not touch this surface. Junction unit (18) is preferably positioned on the back sheet (15).

In the invention, size of the membrane (17), namely surface area of the membrane (17), is greater than all other layers (11, 12, 13, 14, 15, 16). The size of the front face protection layer (11) is in a size, that is enough to cover the size of the solar cell layer (13). The size of the back sheet (15), is greater than front face protection layer's (11) and solar cell layer's (13) surface areas and less than membrane's (17) surface area. Back sheet (15) comprises a protrusion (151) for positioning of the junction unit (18). This protrusion (151), overhangs from the short edge of the back sheet (15) in one embodiment of the invention.

Upper, lower and lowermost protection layers (12, 14 and 16), have sizes equal to each other whereby these sizes, namely surface areas are greater than the surface area of the front face protection layer (11) in such a manner that they overhang from this surface area in a predetermined amount. By this means, impermeability function is gained to solar panel (1). By means of overhanging of upper, lower and lowermost protection layers (12, 14 and 16) from front face protection layer's (11) edges (i.e. sides), sealing of layers between front face protection layer (11) and membrane (17) are provided. Thus, all main layers (11, 13, 15, 17) are sealed to each other, including membrane (17) and front face protection layer (11). Therefore, entering of water between membrane (17) and front face protection layer (11) and delamination of the panel (1) are prevented during commercial lifetime of the solar panel (1), (minimum for 25 years). According to the test results, solar panel (1) can produce electricity efficiently at least 25 years by this regard.

In a preferred embodiment of the invention, the sides of upper, lower and lowermost protection layers (12, 14 and 16) are dimensioned such that the cited sides protrude out of the front face protection layer's (11) sides 2 cm each.

In the invention, layers have preferably rectangular surface areas.

In the invention, the ratio of a long side of the front face protection layer (11) to a long side of the membrane (17) is between 0,6 to 1 or equal to one of these numbers, i.e.:

$$0,6 <= \text{long side of the front face protection layer (11) / long side of the membrane (17)} <= 1$$

The ratio of a short side of the front face protection layer (11) to a short side of the membrane (17) is between 0,5 to 1 or equal to one of these numbers, i.e.:

$$0,5 <= \text{short side of the front face protection layer (11) / short side of the membrane (17)} <= 1$$

The ratio of the distance between a short side length of the membrane (17) and a short side of the front face protection layer (11) to the cited short side's length of the membrane (17) is between 0 to 1 or equal to one of these numbers.

The ratio of the distance between a long side (i.e. edge) length of the membrane (17) and a long side (i.e. edge) of the front face protection layer (11) to the cited long side's length of the membrane (17) is between 0 to 1 or equal to one of these numbers, i.e.:

$$0 <= \text{the distance between, length of the one edge of the membrane (17) - length of the one edge, which is on the same side (i.e. part) of the membrane's edge, of the front face protection layer (11) / cited edge length of the membrane (17)} <= 1$$

When the distance between membrane (17) and front face protection layer (11) is much, solar efficiency of the solar panel (1) mounted roof decreases; and if it is short, this time efficiency increases but montage of the solar panel (1) to the roof gets harder. In the second case, montage gets more difficult because the size of the front face protection layer (11) increases and thereby the weight also increases. Therefore, the above cited ratios are optimum ratios, whereby panel (1) is mounted easily, the production is the most practical and the efficiency does not decrease at the same time.

In one embodiment of the invention, long side of the front face protection layer (11) is approximately 1600 mm and the short side is approximately 998 mm. In this embodiment, long side of the membrane (17) is approximately 1840 mm and the short side is approximately 1138 mm. In this embodiment, when we face the solar panel (1) in front of us, the distance between membrane and glass, wherein the distance remains at the top (i.e. at the junction unit's (18) side), is approximately 170 mm.

Solar panel (1) subject to the invention, provides electrical isolation conditions according to the standard of IEC61215-1. This panel (1) isolates electrically voltage of 1000 Volts.

When solar panel (1) subject to the invention is montaged to an industrial roof, it constitutes an integrated system with the roof. Panel (1) sticks to the roof totally and therefore, it integrates with the roof. Thanks to this, the sustainability of the insulation is provided and panel is not effected from natural events like wind and storm.

In the invention, thanks to the alignment, structure and contents of the layers, panel (1) is lightened and rendered to a construction such that 1 single person can easily make roof installation (montage).

As panel (1) subject to the invention is suitable for the lamination process to be applied to the roof, also breakdown of the insulation of the roof is prevented. Therefore, the integrity of the roof is not damaged as well. Due to the structure as described above and due to the installation via lamination, this panel (1) combines with the insulation and also increases the insulation of the roof.

The invention is not limited with the disclosed embodiments above, a skilled person in the art can produce different embodiments of the invention easily. They should be evaluated within the scope of invention protection demanded with claims.

## Claims

1. A solar panel (1) comprising a membrane (17) as a base layer wherein the base layer is to be integrated to an industrial roof and from the bottom to the uppermost layer respectively: a lowermost protection layer (16) on this membrane (17); electrical isolation back sheet (15) on this lowermost protection layer (16); a lower protection layer (14) on this electrical isolation back sheet (15); a solar cell layer (13) having solar cells (131) that provide electricity production, on this lower protection layer (14); an upper protection layer (12) on this solar cell layer (13); and a front face protection layer (11) on this upper protection layer (12) and also comprising a junction unit (18), that provides the solar cell layer (13) to produce electrical output **characterized in that** the upper, lower and lowermost protection layers (12, 14 and 16) have surface area sizes equal to each other in a way to provide sealing of the front face protection (11), the solar cell (13), the electrical isolation back sheet (15) and the membrane (17) layers to each other and whereby said surface area sizes are greater than the surface area of the front face protection layer (11) in such a manner that the upper, lower and lowermost protection layers (12, 14, 16) overhang from said front face protection layer (11) by a predetermined amount.

2. A solar panel (1) according to Claim 1, wherein upper, lower and lowermost protection layers (12, 14 and 16) are EVA (Ethylene Vinyl Acetate) membrane.

3. A solar panel (1) according to Claim 1 or 2, wherein the front face protection layer (11) is a tempered glass.

4. A solar panel (1) according to any of the previous claims, wherein the membrane (17) comprises a TPO thermoplastic polyolefin and/or PVC Polyvinyl Chloride.

5. A solar panel (1) according to any of the previous claims, whereby the junction unit (18) is placed in such a way that it does not prevent the membrane's (17) lower surface to be laminated to the roof.

6. A solar panel (1) according to claim 5, wherein, the junction unit (18) is positioned on the back sheet (15).

7. A solar panel (1) according to claim 6, wherein back sheet (15) comprises a protrusion (151) for positioning of the junction unit (18).

8. A solar panel (1) according to claim 7, wherein the protrusion (151), overhangs from the short edge of the back sheet (15).

9. A solar panel (1) according to claim 7 or 8, wherein the junction unit (18) is positioned on the protrusion (151).

10. A solar panel (1) according to claim 5, wherein the junction unit (18) is positioned on the front face protection layer.

11. A solar panel (1) according to any of the previous claims, wherein the surface area of the membrane (17), is greater than surface areas of the front face protection layer (11), upper protection layer (12), solar cell layer (13), lower protection layer (14), back sheet (15) and lowermost protection layer (16).

12. A solar panel (1) according to any of the previous claims, wherein the size of the surface area of the front face protection layer (11) is such that, it is enough to cover the size of the surface area of the solar cell layer (13).

13. A solar panel (1) according to any of the previous claims, wherein the surface area of the back sheet (15) is greater than the surface area of the front face protection layer (11) and solar cell layer (13) and less than the surface area of the membrane (17).

14. A solar panel (1) according to claim 1, wherein the upper, lower and lowermost protection layers (12, 14 and 16) are dimensioned such that they overhang out of the front face protection layer's (11) sides by 2 cm.

15. A solar panel (1) according to any of the previous claims, wherein the ratio of a long side of the front face protection layer (11) to a long side of the membrane (17) is between 0,6 to 1 or equal to one of these numbers.

16. A solar panel (1) according to any of the previous claims, wherein the ratio of a short side of the front face protection layer (11) to a short side of the membrane (17) is between 0,5 to 1 or equal to one of these numbers.

17. A solar panel (1) according to any of the previous claims, wherein the ratio of the distance between a short or long side length of the membrane (17) and a short or long side of the front face protection layer (11) to the said short or long side's length of the membrane (17) is between 0 to 1 or equal to one of these numbers.

18. A solar panel (1) according to any of the previous claims, wherein the long side of the front face protection layer (11) is 16 cm and short side is 10 cm and long side of the membrane (17) is 18 cm and short side is 12 cm.


**Patentansprüche**

1. Solarpanel (1) mit einer Membran (17) als einer Grundschicht, wobei die Grundschicht auf einem Industriedach anzuordnen ist, und von unten bis zur obersten Schicht jeweils mit:
   einer untersten Schutzschicht (16) auf der Membran (17), einer elektrisch isolierenden Rückseitenfolie (15) auf der untersten Schutzschicht (16), einer unteren Schutzschicht (14) auf der elektrisch isolierenden Rückseitenfolie (15), einer Solarzellschicht (13) mit Solarzellen (131), die Elektrizität produzieren, auf der unteren Schutzschicht (14), einer oberen Schutzschicht (12) auf der Solarzellschicht (13) und einer Vorderseiten-Schutzschicht (11) auf der oberen Schutzschicht (12) und mit einer Verbindungseinheit (18), die dafür sorgt, dass die Solarzellschicht (13) eine elektrische Ausgabe produziert, **dadurch gekennzeichnet, dass** die obere, die untere und die unterste Schutzschicht (12, 14 und 16) Oberflächengrößen aufweisen, die einander gleichen, um ein Abdichten der Vorderseiten-Schutzschicht (11), der Solarzellschicht (13), der elektrisch isolierenden Rückseitenschicht (15) und der Membranschicht (17) zueinander zu bewirken, und wobei die Oberflächengrößen größer sind als die Oberflächen der Vorderseiten-Schutzschicht (11), dergestalt dass die obere, die untere und die unterste Schutzschicht (12, 14, 16) bis zu einem bestimmten Grad über die Vorderseiten-Schutzschicht (11) überstehen.

2. Solarpanel (1) nach Anspruch 1, wobei die obere, die untere und die unterste Schutzschicht (12, 14 und 16) eine EVA-(Ethylenvinylacetat-)Membran sind.

3. Solarpanel (1) nach Anspruch 1 oder 2, wobei die Vorderseiten-Schutzschicht (11) Hartglas ist.

4. Solarpanel (1) nach einem der vorangehenden Ansprüche, wobei die Membran (17) ein TPO (thermoplastisches Polyolefin) und/oder PVC (Polyvinylchlorid) aufweist.

5. Solarpanel (1) nach einem der vorangehenden Ansprüche, wobei die Verbindungseinheit (18) so angeordnet ist, dass sie nicht verhindert, dass die untere Oberfläche der Membran (17) auf das Dach laminiert werden kann.

6. Solarpanel (1) nach Anspruch 5, wobei die Verbindungseinheit (18) auf der Rückseiten-Folie (15) angeordnet ist.

7. Solarpanel (1) nach Anspruch 6, wobei die Rückseiten-Folie (15) einen Vorsprung (151) zum Positionieren der Verbindungseinheit (18) aufweist.

8. Solarpanel (1) nach Anspruch 7, wobei der Vorsprung (151) von der kurzen Kante der Rückseiten-Folie (15) übersteht.

9. Solarpanel (1) nach Anspruch 7 oder 8, wobei die Verbindungseinheit (18) auf dem Vorsprung (151) angeordnet ist.

10. Solarpanel (1) nach Anspruch 5, wobei die Verbindungseinheit (18) auf der Vorderseiten-Schutzschicht angeordnet ist.

11. Solarpanel (1) nach einem der vorangehenden Ansprüche, wobei die Oberfläche der Membran (17) größer ist als die Oberflächen der Vorderseiten-Schutzschicht (11), der unteren Schutzschicht (12), der Solarzellschicht (13), der unteren Schutzschicht (14), der Rückseiten-Folie (15) und der untersten Schutzschicht (16).

12. Solarpanel (1) nach einem der vorangehenden Ansprüche, wobei die Größe der Oberfläche der Vorderseiten-Schutzschicht (11) groß genug ist, um die Größe der Oberfläche der Solarzellschicht (13) abzudecken.

13. Solarpanel (1) nach einem der vorangehenden Ansprüche, wobei die Oberfläche der Rückseiten-Folie (15) größer ist als die Oberfläche der Vorderseiten-Schutzschicht (11) und der Solarzellschicht (13) und geringer ist als die Oberfläche der Membran (17).

14. Solarpanel (1) nach Anspruch 1, wobei die obere, die untere und die unterste Schutzschicht (12, 14 und 16) so dimensioniert sind, dass sie über die Seiten der Vorderseitenschutzschicht (11) um 2 cm überstehen.

15. Solarpanel (1) nach einem der vorangehenden Ansprüche, wobei das Verhältnis einer langen Seite der Vorderseiten-Schutzschicht (11) zu einer langen Seite der Membran (17) zwischen 0,6 bis 1 oder gleich einer dieser Zahlen ist.

16. Solarpanel (1) nach einem der vorangehenden Ansprüche, wobei das Verhältnis einer kurzen Seite der Vorderseiten-Schutzschicht (11) zu einer kurzen Seite der Membran (17) zwischen 0,5 oder 1 oder gleich einer dieser Zahlen ist.

17. Solarpanel (1) nach einem der vorangehenden Ansprüche, wobei das Verhältnis des Abstandes wischen einer kurzen oder langen Seitenlänge der Membran (17) und einer kurzen oder langen Seite der Vorderseiten-Schutzschicht (11) zu der kurzen oder langen Seitenlänge der Membran (17) zwischen 0 bis 1 oder gleich einer dieser Zahlen ist.

18. Solarpanel (1) nach einem der vorangehenden Ansprüche, wobei die lange Seite der Vorderseiten-Schutzschicht (11) 16 cm ist und die kurze Seite 10 cm ist und die lange Seite der Membran (17) 18 cm ist und die kurze Seite 12 cm ist.

**Revendications**

1. Panneau solaire (1) comprenant une membrane (17) en tant que couche de base, la couche de base étant destinée à être intégrée à un toit industriel et, de la couche inférieure à la couche la plus haute, respectivement : une couche de protection la plus basse (16) sur cette membrane (17) ; une feuille support d'isolation électrique (15) sur cette couche de protection la plus basse (16) ; une couche de protection inférieure (14) sur cette feuille support d'isolation électrique (15) ; une couche de cellule solaire (13) ayant des cellules solaires (131) qui assurent la production d'électricité, sur cette couche de protection inférieure (14) ; une couche de protection supérieure (12) sur cette couche de cellule solaire (13) ; et une couche de protection de face avant (11) sur cette couche de protection supérieure (12) et comprenant également une unité de jonction (18), qui permet à la couche de cellule solaire (13) de produire une sortie électrique, **caractérisé par le fait que** les couches de protection supérieure, inférieure et la plus basse (12, 14 et 16) ont des aires de surface égales les unes aux autres de manière à assurer une étanchéité des couches de protection de face avant (11), de cellule solaire (13), de feuille support d'isolation électrique (15) et de membrane (17) les unes par rapport aux autres et ce par quoi lesdites aires de surface sont supérieures à l'aire de surface de la couche de protection de face avant (11) d'une manière telle que les couches de protection supérieure, inférieure et la plus basse (12, 14, 16) dépassent de ladite couche de protection de face avant (11) d'une quantité prédéterminée.

2. Panneau solaire (1) selon la revendication 1, dans lequel les couches de protection supérieure, inférieure et la plus basse (12, 14 et 16) sont des membranes en EVA (éthylène-acétate de vinyle).

3. Panneau solaire (1) selon la revendication 1 ou 2, dans lequel la couche de protection de face avant (11) est un verre trempé.

4. Panneau solaire (1) selon l'une quelconque des revendications précédentes, dans lequel la membrane (17) comprend une polyoléfine thermoplastique TPO et/ou du polychlorure de vinyle PVC.

5. Panneau solaire (1) selon l'une quelconque des revendications précédentes, dans lequel l'unité de jonction (18) est placée d'une manière telle qu'elle n'empêche pas la surface inférieure de la membrane (17) d'être plaquée sur le toit.

6. Panneau solaire (1) selon la revendication 5, dans lequel l'unité de jonction (18) est positionnée sur la feuille support (15).

7. Panneau solaire (1) selon la revendication 6, dans lequel la feuille support (15) comprend une saillie (151) pour le positionnement de l'unité de jonction (18).

8. Panneau solaire (1) selon la revendication 7, dans lequel la saillie (151) dépasse du bord court de la feuille support (15).

9. Panneau solaire (1) selon la revendication 7 ou 8, dans lequel l'unité de jonction (18) est positionnée sur la saillie (151).

10. Panneau solaire (1) selon la revendication 5, dans lequel l'unité de jonction (18) est positionnée sur la couche de protection de face avant.

11. Panneau solaire (1) selon l'une quelconque des revendications précédentes, dans lequel l'aire de surface de la membrane (17) est supérieure aux aires de surface de la couche de protection de face avant (11), de la couche de protection supérieure (12), de la couche de cellule solaire (13), de la couche de protection inférieure (14), de la feuille support (15) et de la couche de protection la plus basse (16).

12. Panneau solaire (1) selon l'une quelconque des revendications précédentes, dans lequel la taille de l'aire de surface de la couche de protection de face avant (11) est telle qu'elle est suffisante pour couvrir la taille de l'aire de surface de la couche de cellule solaire (13).

13. Panneau solaire (1) selon l'une quelconque des revendications précédentes, dans lequel l'aire de surface de la feuille support (15) est supérieure à l'aire de surface de la couche de protection de face avant (11) et de la couche de cellule solaire (13) et inférieure à l'aire de surface de la membrane (17).

14. Panneau solaire (1) selon la revendication 1, dans lequel les couches de protection supérieure, inférieure et la plus basse (12, 14 et 16) sont dimensionnées de telle sorte qu'elles dépassent des côtés de la couche de protection de face avant (11) de 2 cm.

15. Panneau solaire (1) selon l'une quelconque des revendications précédentes, dans lequel le rapport d'un côté long de la couche de protection de face avant (11) à un côté long de la membrane (17) est compris entre 0,6 et 1 ou égal à l'un de ces nombres.

16. Panneau solaire (1) selon l'une quelconque des revendications précédentes, dans lequel le rapport d'un petit côté de la couche de protection de face avant (11) à un petit côté de la membrane (17) est compris entre 0,5 et 1 ou égal à l'un de ces nombres.

17. Panneau solaire (1) selon l'une quelconque des revendications précédentes, dans lequel le rapport de la distance entre une longueur de côté court ou long de la membrane (17) et un côté court ou long de la couche de protection de face avant (11), à la longueur dudit côté court ou long de la membrane (17) est compris entre 0 et 1 ou égal à l'un de ces nombres.

18. Panneau solaire (1) selon l'une quelconque des revendications précédentes, dans lequel le côté long de la couche de protection de face avant (11) est de 16 cm et le côté court, de 10 cm, et le côté long de la membrane (17) est de 18 cm et le côté court, de 12 cm.

Figure 1

**Figure 2**

1

11

12

13

131

14

15

16

17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102015118683 A1